# EUROPÄISCHE PATENTANMELDUNG

(11) **EP 2 959 990 A1**
(43) Veröffentlichungstag der Anmeldung: **30.12.2015**
(21) Anmeldenummer: 14174684.2
(22) Anmeldetag: 27.06.2014
(51) Int. Cl.: B22F 1/00, B22F 7/04, B23K 35/34, B23K 35/36, B23K 35/365, B23K 35/02, H01L 23/00

(54) **METALLZUBEREITUNG UND DEREN VERWENDUNG ZUM VERBINDEN VON BAUELEMENTEN**

(71) Anmelder: Heraeus Deutschland GmbH & Co. KG, 63450 Hanau (DE)
(72) Erfinder: Schäfer, Michael, 36093 Künzell (DE); Schmitt, Wolfgang, 63110 Rodgau (DE)
(74) Vertreter: Heraeus IP

(57) **Zusammenfassung**

Metallzubereitung, die (A) 40 bis < 80 Gew.-% wenigstens eines Metalls, das in Form von Partikeln vorliegt, die ein Coating aufweisen, das wenigstens eine organische Verbindung enthält, und (B) > 20 bis 50 Gew.-% organisches Lösemittel umfasst.

## Beschreibung

Die vorliegende Erfindung betrifft eine Metallzubereitung und ein Verfahren zum Verbinden von Bauelementen, bei dem diese Metallzubereitung eingesetzt wird.

Im Bereich der Leistungs- und Konsumerelektronik stellt das Verbinden von Bauelementen, wie LEDs oder sehr dünnen Siliziumchips, die eine hohe Druck- und Temperaturempfindlichkeit aufweisen, eine besondere Herausforderung dar.

Aus diesem Grund werden solche druck- und temperaturempfindlichen Bauelemente häufig durch Kleben miteinander verbunden. Die Klebetechnik besitzt jedoch den Nachteil, dass damit Kontaktstellen zwischen den Bauelementen geschaffen werden, die eine nur unzureichende Wärmeleitfähigkeit bzw. elektrische Leitfähigkeit aufweisen.

Um dieses Problem zu lösen, werden die zu verbindenden Bauelemente häufig gesintert. Die Sintertechnik stellt ein sehr einfaches Verfahren zum stabilen Verbinden von Bauelementen dar. Dabei werden sogenannte Sinterpasten eingesetzt und durch Druckverfahren wie Schablonendruck oder Siebdruck oder durch Dispensen appliziert.

Das Arbeiten mit herkömmlichen Metallsinterpasten stößt an Grenzen, sobald Bauelemente mit problematischer Oberflächenbeschaffenheit mittels Sinterverfahren verbunden werden sollen. Im Rahmen der Erfindung sind unter Bauelementen mit problematischer Oberflächenbeschaffenheit insbesondere solche zu verstehen, die eine nichtebene und/oder saugende und/oder offenporige Oberfläche und/oder eine komplizierte Oberflächentopographie aufweisen.

Im Rahmen der Erfindung sind unter Bauelementen mit komplizierter Oberflächentopographie insbesondere solche zu verstehen, die eine Vertiefungen (Kavitäten) und/oder Wölbungen und/oder Krümmungen und/oder Sicken aufweisende und/oder raue Oberfläche aufweisen.

Aufgabe der Erfindung ist die Bereitstellung eines Sinterverfahrens zur stabilen Verbindung von Bauelementen, insbesondere auch solcher Bauelemente mit einer problematischen Oberflächenbeschaffenheit. Mit dem Verfahren sollen Kontaktstellen zwischen zu verbindenden Bauelementen gebildet werden, die eine niedrige Porosität und eine hohe elektrische und thermische Leitfähigkeit aufweisen. Eine weitere Aufgabe der vorliegenden Erfindung besteht darin, eine zur Durchführung eines derartigen Sinterverfahrens geeignete Metallzubereitung bereitzustellen.

Die Erfindung betrifft ein Verfahren zum Verbinden von Bauelementen, bei dem man (a) eine Sandwichanordnung bereitstellt, die wenigstens (a1) ein Bauelement 1, (a2) ein Bauelement 2 und (a3) ein Sintermittel aufweist, das sich zwischen Bauelement 1 und Bauelement 2 befindet, und (b) die Sandwichanordnung sintert, dadurch gekennzeichnet, dass das Sintermittel aus einer Metallzubereitung, die (A) 40 bis < 80 Gew.-% (Gewichts-%) wenigstens eines Metalls, das in Form von Partikeln vorliegt, die ein Coating aufweisen, das wenigstens eine organische Verbindung enthält, und (B) > 20 bis 50 Gew.-% organisches Lösemittel umfasst, durch Sprühauftrag appliziert worden ist.

Die Erfindung betrifft ferner eine Metallzubereitung, die (A) 40 bis < 80 Gew.-% wenigstens eines Metalls, das in Form von Partikeln vorliegt, die ein Coating aufweisen, das wenigstens eine organische Verbindung enthält, und (B) > 20 bis 50 Gew.-% organisches Lösemittel umfasst.

Die erfindungsgemäße Metallzubereitung enthält 40 bis < 80 Gew.-%, vorzugsweise 50 bis < 80 Gew.-%, mehr bevorzugt 60 bis 75 Gew.-% wenigstens eines Metalls, das in Form von Partikeln vorliegt, die ein Coating aufweisen, das wenigstens eine organische Verbindung enthält. Die hier gemachten Gewichtsangaben schließen das Gewicht der Coatingverbindungen auf den Partikeln mit ein.

Unter den Begriff Metall fallen sowohl reine Metalle als auch Metalllegierungen.

Im Rahmen der Erfindung bezieht sich der Begriff Metall auf Elemente, die im Periodensystem der Elemente in der selben Periode wie Bor, aber links von Bor, in der selben Periode wie Silizium, aber links von Silizium, in der selben Periode wie Germanium, aber links von Germanium, und in der selben Periode wie Antimon, aber links von Antimon stehen, sowie auf alle Elemente, die eine höhere Ordnungszahl als 55 aufweisen.

Als reine Metalle werden im Rahmen der Erfindung Metalle verstanden, die ein Metall mit einer Reinheit von wenigstens 95 Gew.-%, bevorzugt wenigstens 98 Gew.-%, mehr bevorzugt wenigstens 99 Gew.-% und noch mehr bevorzugt wenigstens 99,9 Gew.-% enthalten.

Gemäß einer bevorzugten Ausführungsform handelt es sich bei dem Metall um Kupfer, Silber, Gold, Nickel, Palladium, Platin oder Aluminium, insbesondere Silber.

Als Metalllegierungen werden metallische Gemische aus wenigstens zwei Komponenten verstanden, von denen wenigstens eine ein Metall ist.

Gemäß einer bevorzugten Ausführungsform wird als Metalllegierung eine Legierung eingesetzt, die Kupfer, Aluminium, Nickel und/oder Edelmetalle enthält. Die Metalllegierung umfasst vorzugsweise wenigstens ein Metall, das aus der Gruppe ausgewählt ist, die aus Kupfer, Silber, Gold, Nickel, Palladium, Platin und Aluminium besteht. Besonders bevorzugte Metalllegierungen enthalten wenigstens zwei Metalle, die aus der Gruppe ausgewählt sind, die aus Kupfer, Silber, Gold, Nickel, Palladium, Platin und Aluminium besteht. Es kann ferner bevorzugt sein, dass der Anteil der Metalle, die aus der Gruppe ausgewählt sind, die aus Kupfer, Silber, Gold, Nickel, Palladium, Platin und Aluminium besteht, an der Metalllegierung wenigstens 90 Gew.-%, vorzugsweise wenigstens 95 Gew.-%, mehr bevorzugt wenigstens 99 Gew.-% und noch mehr bevorzugt 100 Gew.-% beträgt. Bei der Legierung kann es sich beispielsweise um eine Legierung handeln, die Kupfer und Silber, Kupfer, Silber und Gold, Kupfer und Gold, Silber und Gold, Silber und Palladium, Platin und Palladium oder Nickel und Palladium enthält.

In der erfindungsgemäßen Metallzubereitung können als Metall ein reines Metall, mehrere Arten von reinen Metallen, eine Art von Metalllegierung, mehrere Arten von Metalllegierungen oder Mischungen davon enthalten sein.

Das Metall liegt in der Metallzubereitung in Form von Partikeln vor.

Die Metallpartikel können von unterschiedlicher Gestalt sein. Beispielsweise können die Metallpartikel in der Form von Flakes oder einer sphärischen (kugeligen) Form vorliegen. Gemäß einer besonders bevorzugten Ausführungsform weisen die Metallpartikel die Form von Flakes auf. Dies schließt jedoch nicht aus, dass von den eingesetzten Metallpartikeln auch ein untergeordneter Anteil eine andere Form aufweisen kann. Es ist jedoch bevorzugt, dass wenigstens 70 Gew.-%, mehr bevorzugt wenigstens 80 Gew.-%, noch mehr bevorzugt wenigstens 90 Gew.-% oder 100 Gew.-% der Partikel in der Form von Flakes vorliegen.

Die Metallpartikel sind gecoatet.

Unter einem Coating von Partikeln wird eine festhaftende Schicht auf der Oberfläche von Partikeln verstanden.

Das Coating der Metallpartikel enthält wenigstens eine Art von Coatingverbindungen.

Bei diesen Coatingverbindungen handelt es sich um organische Verbindungen.

Bei den organischen Verbindungen, die als Coatingverbindungen dienen, handelt es sich um kohlenstoffhaltige Verbindungen, die eine Agglomeration der Metallpartikel verhindern.

Gemäß einer bevorzugten Ausführungsform tragen die Coatingverbindungen wenigstens eine funktionelle Gruppe. Als funktionelle Gruppen kommen insbesondere Carbonsäuregruppen, Carboxylatgruppen, Estergruppen, Ketogruppen, Aldehydgruppen, Aminogruppen, Amidgruppen, Azogruppen, Imidgruppen oder Nitrilgruppen in Betracht. Bevorzugte funktionelle Gruppen sind Carbonsäuregruppen und Carbonsäureestergruppen. Die Carbonsäuregruppe kann deprotoniert sein.

Bei den Coatingverbindungen mit wenigstens einer funktionellen Gruppe handelt es sich vorzugsweise um gesättigte, einfach ungesättigte oder mehrfach ungesättigte organische Verbindungen.

Diese Coatingverbindungen mit wenigstens einer funktionellen Gruppe können ferner verzweigt oder unverzweigt sein.

Die Coatingverbindungen mit wenigstens einer funktionellen Gruppe weisen vorzugsweise 1 bis 50, mehr bevorzugt 2 bis 24, noch mehr bevorzugt 6 bis 24 und noch mehr bevorzugt 8 bis 20 Kohlenstoffatome auf.

Die Coatingverbindungen können ionisch oder nichtionisch sein.

Vorzugsweise kommen als Coatingverbindungen freie Fettsäuren, Fettsäuresalze oder Fettsäureester zum Einsatz.

Die freien Fettsäuren, Fettsäuresalze und Fettsäureester sind vorzugsweise unverzweigt.

Ferner sind die freien Fettsäuren, Fettsäuresalze oder Fettsäureester vorzugsweise gesättigt.

Bevorzugte Fettsäuresalze sind die Salze von Ammonium, Monoalkylammonium, Dialkylammonium, Trialkylammonium, Aluminium, Kupfer, Lithium, Natrium und Kalium.

Bevorzugte Ester sind Alkylester, insbesondere Methylester, Ethylester, Propylester und Butylester.

Gemäß einer bevorzugten Ausführungsform handelt es sich bei den freien Fettsäuren, Fettsäuresalzen oder Fettsäureestern um Verbindungen mit 8 bis 24, mehr bevorzugt 10 bis 24 und noch mehr bevorzugt 12 bis 18 Kohlenstoffatomen.

Bevorzugte Coatingverbindungen sind Caprylsäure (Octansäure), Caprinsäure (Decansäure), Laurinsäure (Dodecansäure), Myristinsäure (Tetradecansäure), Palmitinsäure (Hexadecansäure), Margarinsäure (Heptadecansäure), Stearinsäure (Octadecansäure), Arachinsäure (Eicosansäure/Icosansäure), Behensäure (Docosansäure), Lignocerinsäure (Tetracosansäure) sowie die entsprechenden Ester und Salze.

Besonders bevorzugte Coatingverbindungen sind Dodecansäure, Octadecansäure, Aluminiumstearat, Kupferstearat, Natriumstearat, Kaliumstearat, Natriumpalmitat und Kaliumpalmitat.

Die Coatingverbindungen können mittels herkömmlicher und aus dem Stand der Technik bekannter Verfahren auf die Oberfläche der Metallpartikel aufgetragen werden.

Beispielsweise ist es möglich, die Coatingverbindungen, insbesondere die vorstehend erwähnten Stearate oder Palmitate, in Lösemitteln aufzuschlämmen und die aufgeschlämmten Coatingverbindungen in Kugelmühlen mit den Metallpartikeln zu vermahlen. Nach dem Mahlen werden die mit den Coatingverbindungen beschichteten Metallpartikel getrocknet und anschließend entstaubt.

Vorzugsweise beträgt der Anteil an organischen Verbindungen, insbesondere der Anteil an Verbindungen, die aus der Gruppe ausgewählt sind, die aus freien Fettsäuren, Fettsäuresalzen und Fettsäureestern besteht, die vorzugsweise 8 bis 24, mehr bevorzugt 10 bis 24 und noch mehr bevorzugt 12 bis 18 Kohlenstoffatome aufweisen, an dem gesamten Coating wenigstens 60 Gew.-%, mehr bevorzugt wenigstens 70 Gew.-%, noch mehr bevorzugt wenigstens 80 Gew.-%, noch mehr bevorzugt wenigstens 90 Gew.-%, insbesondere wenigstens 95 Gew.-%, wenigstens 99 Gew.-% oder 100 Gew.-%.

Üblicherweise beträgt der Anteil der Coatingverbindungen, vorzugsweise der Coatingverbindungen, die aus der Gruppe ausgewählt sind, die aus freien Fettsäuren, Fettsäuresalzen und Fettsäureestern mit 8 bis 24, mehr bevorzugt 10 bis 24 und noch mehr bevorzugt 12 bis 18 Kohlenstoffatomen besteht, 0,01 bis 2 Gew.-%, vorzugsweise 0,3 bis 1,5 Gew.-%, bezogen auf das Gewicht der gecoateten Metallpartikel.

Der Coatinggrad, der als Verhältnis der Masse an Coatingverbindungen zur Oberfläche der Metallpartikel definiert ist, beträgt vorzugsweise 0,00005 bis 0,03 g, mehr bevorzugt 0,0001 bis 0,02 g an Coatingverbindungen pro Quadratmeter (m²) Oberfläche der Metallpartikel.

Die erfindungsgemäße Metallzubereitung enthält > 20 bis 50 Gew.-%, vorzugsweise 25 bis 40 Gew.-% organisches Lösemittel (B), d.h. ein organisches Lösemittel oder ein Gemisch mindestens zweier organischer Lösemittel.

Bei dem oder den organischen Lösemitteln handelt es sich um als Bestandteile von dem Fachmann bekannten und eingangs schon erwähnten Metallsinterpasten üblicherweise verwendete organische Lösemittel. Beispiele sind Terpineole, N-Methyl-2-pyrrolidon, Ethylenglykol, Dimethylacetamid, 1-Tridecanol, 2-Tridecanol, 3-Tridecanol, 4-Tridecanol, 5-Tridecanol, 6-Tridecanol, Isotridecanol, mit Ausnahme einer Methylsubsitution am vorletzten C-Atom unsubstituierte 1-Hydroxy-C16-C20-alkane wie 16-Methylheptadecan-1-ol, dibasische Ester (vorzugsweise Dimethylester der Glutar-, Adipin- oder Bernsteinsäure oder Mischungen davon), Glycerin, Diethylenglykol, Triethylenglykol und aliphatische, insbesondere gesättigte aliphatische Kohlenwasserstoffe mit 5 bis 32 C-Atomen, mehr bevorzugt 10 bis 15 C-Atomen und noch mehr bevorzugt 10 bis 13 C-Atomen. Solche aliphatischen Kohlenwasserstoffe werden beispielsweise von Exxon Mobil unter der Marke Exxsol™ oder unter der Marke Isopar M™ vertrieben.

Die erfindungsgemäße Metallzubereitung kann 0 bis 12 Gew.-%, vorzugsweise 0,1 bis 12 Gew.-%, mehr bevorzugt 1 bis 10 Gew.-% und noch mehr bevorzugt 2 bis 8 Gew.-% wenigstens eines Metallprecursors (C) enthalten.

Unter Metallprecursor wird im Rahmen der Erfindung eine Verbindung verstanden, die wenigstens ein Metall enthält und unter Freisetzung des Metalls zersetzbar ist. Vorzugsweise handelt es sich dabei um eine Verbindung, die sich bei Temperaturen von unterhalb 200°C unter Freisetzung des Metalls zersetzt. Vorzugsweise wird demnach bei Verwendung eines Metallprecursors beim Sinterprozess in situ ein Metall gebildet. Es kann auf einfache Weise ermittelt werden, ob es sich bei einer Verbindung um einen Metallprecursor handelt. So kann beispielsweise eine Zubereitung, die eine zu testende Verbindung enthält, auf ein Substrat mit einer Silberoberfläche abgeschieden, auf 200°C erhitzt und bei dieser Temperatur für 20 Minuten belassen werden. Danach wird überprüft, ob sich unter diesen Bedingungen die zu testende Verbindung zu einem Metall zersetzt hat. Hierzu kann beispielsweise vor dem Test der Gehalt der metallhaltigen Zubereitungsbestandteile ausgewogen und daraus die theoretische Masse des Metalls berechnet werden. Nach dem Test wird die Masse des auf dem Substrat abgeschiedenen Materials gravimetrisch bestimmt. Entspricht die Masse des auf dem Substrat abgeschiedenen Materials der theoretischen Masse des Metalls, wobei die üblichen Messabweichungen zu berücksichtigen sind, handelt es sich bei der getesteten Verbindung um einen Metallprecursor.

Gemäß einer bevorzugten Ausführungsform handelt es sich bei dem Metallprecursor um einen endotherm zersetzbaren Metallprecursor. Unter endotherm zersetzbarem Metallprecursor soll ein Metallprecursor verstanden werden, dessen thermische Zersetzung, vorzugsweise unter Schutzgasatmosphäre, einen endothermen Vorgang darstellt. Bei dieser thermischen Zersetzung soll es zur Freisetzung von Metall aus dem Metallprecursor kommen.

Gemäß einer weiteren bevorzugten Ausführungsform weist der Metallprecursor ein Metall auf, das auch im partikelförmigen Metall (A) enthalten ist.

Vorzugsweise umfasst der Metallprecursor als Metall wenigstens ein Element, das aus der Gruppe ausgewählt ist, die aus Kupfer, Silber, Gold, Nickel, Palladium und Platin besteht.

Es kann bevorzugt sein, als Metallprecursor zersetzbare Carbonate, Lactate, Formiate, Citrate, Oxide oder Fettsäuresalze, vorzugsweise Fettsäuresalze mit 6 bis 24 Kohlenstoffatomen, der genannten Metalle zu verwenden.

In besonderen Ausführungsformen werden als Metallprecursor Silbercarbonat, Silber(I)lactat, Silber(II)-formiat, Silbercitrat, Silberoxid (zum Beispiel AgO oder Ag₂O), Kupfer(II)-lactat, Kupferstearat, Kupferoxide (zum Beispiel Cu₂O oder CuO) oder Goldoxide (zum Beispiel Au₂O oder AuO) eingesetzt.

Gemäß einer besonders bevorzugten Ausführungsform wird als Metallprecursor Silbercarbonat, Silber(I)-oxid oder Silber(II)-oxid verwendet.

Falls vorhanden, liegt der Metallprecursor in der Metallzubereitung vorzugsweise in der Form von Partikeln vor.

Die Metallprecursor-Partikel können die Form von Flakes oder eine sphärische (kugelige) Form aufweisen. Vorzugsweise liegen die Partikel des Metallprecursors als Flakes vor.

Die erfindungsgemäße Metallzubereitung kann ferner 0 bis 10 Gew.-%, vorzugsweise 0 bis 8 Gew.-% wenigstens eines Sinterhilfsmittels (D) enthalten. Beispiele für Sinterhilfsmittel sind organische Peroxide, anorganische Peroxide und anorganische Säuren, wie beispielsweise in WO2011/026623 A1 beschrieben.

Die erfindungsgemäße Metallzubereitung kann neben den vorstehend erläuterten Bestandteilen (A) bis (D) 0 bis 15 Gew.-%, vorzugsweise 0 bis 12 Gew.-%, mehr bevorzugt 0,1 bis 10 Gew.-% eines oder mehrerer weiterer Inhaltsstoffe (E) enthalten. Bei diesen weiteren Inhaltsstoffen kann es sich vorzugsweise um üblicherweise in Metallsinterpasten eingesetzte Inhaltsstoffe handeln. Beispielsweise können in der erfindungsgemäßen Metallzubereitung als weitere Inhaltsstoffe Dispersionsmittel, Tenside, Entschäumer, Bindemittel, Polymere wie Cellulosederivate, beispielsweise Methylcellulose, Ethylcellulose, Ethylmethylcellulose, Carboxycellulose, Hydroxypropylcellulose, Hydroxyethylcellulose, Hydroxymethylcellulose, und/oder viskositätssteuernde Mittel enthalten sein.

Demgemäß enthält die erfindungsgemäße Metallzubereitung neben den Bestandteilen (A) und (B) 0 bis 12 Gew.-% wenigstens eines Metallprecursors (C), 0 bis 10 Gew.-% wenigstens eines Sinterhilfsmittels (D) und 0 bis 15 Gew.-% eines oder mehrerer weiterer Inhaltsstoffe (E) ausgewählt unter Dispersionsmitteln, Tensiden, Entschäumern, Bindemitteln, Polymeren und/oder viskositätssteuernden Mitteln. In einer Ausführungsform besteht die erfindungsgemäße Metallzubereitung aus den Bestandteilen (A) und (B) sowie 0 bis 12 Gew.-% wenigstens eines Metallprecursors (C), 0 bis 10 Gew.-% wenigstens eines Sinterhilfsmittels (D) und 0 bis 15 Gew.-% eines oder mehrerer weiterer Inhaltsstoffe (E) ausgewählt unter Dispersionsmitteln, Tensiden, Entschäumern, Bindemitteln, Polymeren und/oder viskositätssteuernden Mitteln.

Die Summe der Gew.-% der Bestandteile (A) bis (E) kann beispielsweise 100 Gew.-% betragen, bezogen auf die erfindungsgemäße Metallzubereitung, d.h. vor ihrer Sprühapplikation. Dementsprechend kann die Herstellung der erfindungsgemäßen Metallzubereitung durch Vermischen der Bestandteile (A) bis (E) erfolgen. Dabei können übliche dem Fachmann bekannte Vorrichtungen verwendet werden, beispielsweise Rührwerke. Alternativ können die Bestandteile (A), ein Teil von (B) und (C) bis (E) vermischt werden unter Verwendung beispielsweise von Rührwerken und/oder Dreiwalzwerken, gefolgt von einer Komplettierung durch Vermischen mit dem verbliebenen Anteil von (B).

Die erfindungsgemäße Metallzubereitung weist eine Viskosität auf, die eine Sprühapplikation erlaubt. Beispielsweise liegt die Viskosität in einem Bereich von 1 bis 3 Pa·s, bevorzugt 1,2 bis 2 Pa·s, gemessen nach DIN 53018 (bei 23 °C, CSR-Messung bei einer Scherrate von D = 10 s⁻¹). Die erfindungsgemäße Metallzubereitung kann zur Herstellung eines Sintermittels, insbesondere in Form einer Schicht eines Sintermittels, durch Sprühauftrag und damit in einem Sinterverfahren eingesetzt werden. Unter Sintern wird das Verbinden von zwei oder mehr Bauelementen durch Erhitzen unter Vermeidung dessen, dass die Metallpartikel (A) die flüssige Phase erreichen, verstanden. Dementsprechend betrifft die vorliegende Erfindung, wie schon gesagt, ein Verfahren zum Verbinden von Bauelementen, bei dem man (a) eine Sandwichanordnung bereitstellt, die wenigstens (a1) ein Bauelement 1, (a2) ein Bauelement 2 und (a3) ein Sintermittel aufweist, das sich zwischen den Bauelementen (zwischen den Kontaktflächen bildenden Oberflächen bzw. Oberflächenanteilen der Bauelemente) befindet, und (b) die Sandwichanordnung sintert, dadurch gekennzeichnet, dass das Sintermittel aus einer Metallzubereitung, die (A) 40 bis < 80 Gew.-% wenigstens eines Metalls, das in Form von Partikeln vorliegt, die ein Coating aufweisen, das wenigstens eine organische Verbindung enthält, und (B) > 20 bis 50 Gew.-% organisches Lösemittel umfasst, durch Sprühauftrag appliziert worden ist.

Das erfindungsgemäße Verfahren umfasst demgemäß die Schritte:
(i) Bereitstellen wenigstens zweier Bauelemente 1 und 2,
(ii) Sprühapplizieren der erfindungsgemäßen Metallzubereitung auf eine eine Kontaktfläche bildende Oberfläche oder Oberflächenanteil wenigstens eines der Bauelemente unter Bildung des Sintermittels,
(iii) Ausbilden der besagten Sandwichanordnung durch Verbinden der Bauelemente über das Sintermittel, und
(iv) Sintern der Sandwichanordnung.

Das unter Verwendung des aus der erfindungsgemäßen Metallzubereitung durch Sprühauftrag hergestellten Sintermittels, insbesondere als Schicht vorliegenden Sintermittels, durchgeführte Sinterverfahren kann unter Druckanwendung oder drucklos durchgeführt werden. Drucklose Durchführbarkeit des Sinterverfahrens bedeutet, dass trotz Verzichts auf die Anwendung von mechanischem Druck eine hinreichend feste Verbindung zwischen den Bauelementen erzielt wird. Die Möglichkeit, den Sinterprozess drucklos durchzuführen, erlaubt es, druckempfindliche, beispielsweise zerbrechliche oder in ihrem Gefüge mechanisch empfindliche Bauelemente im Sinterverfahren einzusetzen. In ihrem Gefüge mechanisch empfindliche Elektronikbauelemente erleiden bei unzulässiger Druckbelastung elektrische Fehlfunktionen.

Unter dem Verbinden von wenigstens zwei Bauelementen wird das Befestigen eines ersten Bauelements auf einem zweiten Bauelement verstanden. In diesem Zusammenhang bedeutet "auf" lediglich, dass eine Kontaktfläche des ersten Bauelements mit einer Kontaktfläche des zweiten Bauelements verbunden wird, wobei es auf die relative Lage der beiden Bauelemente oder der Sandwichanordnung, die die wenigstens zwei Bauelemente enthält, nicht ankommt.

Im Rahmen der Erfindung soll der Begriff Bauelement vorzugsweise Einzelteile umfassen. Diese Einzelteile sind vorzugsweise nicht weiter zerlegbar.

Gemäß besonderen Ausführungsformen werden als Bauelemente Bauteile bezeichnet, die in der Elektronik verwendet werden.

Demgemäß kann es sich bei den Bauelementen beispielsweise um Dioden, LEDs (light emitting diodes, lichtemittierende Dioden), DCB (direct copper bonded)-Substrate, Leadframes, MIDs (molded interconnect devices), Dies, IGBTs (insulated-gate bipolar transistors, Bipolartransistoren mit isolierter Gate-Elektrode), ICs (integrated circuits, integrierte Schaltungen), Sensoren, Verbindungselemente (z.B. Clips), Kühlkörper (vorzugsweise Aluminium-Kühlkörper oder Kupfer-Kühlkörper) oder andere passive Bauelemente (zum Beispiel Widerstände, Kondensatoren oder Spulen) handeln.

Die zu verbindenden Bauelemente können gleichartige oder verschiedenartige Bauelemente sein.

Ein besonderer Vorteil der vorliegenden Erfindung liegt darin, dass die Bauelemente nicht zwingend eine ebene Oberfläche oder, präziser ausgedrückt, nicht zwingend eine ebene Kontaktfläche aufweisen müssen, über die die Sandwichanordnung ausgebildet bzw. die Sinterverbindung zwischen den Bauelementen vorgenommen wird. Vielmehr eröffnet die vorliegende Erfindung die Möglichkeit, auch Bauelemente mit problematischer Oberflächenbeschaffenheit über ihre nichtebenen und/oder saugenden und/oder offenporigen und/oder komplizierte Oberflächentopographie aufweisenden Oberflächen bzw. Oberflächenanteile mit anderen Bauelementen zu besagten Sandwichanordnungen zusammenzufügen bzw. per Sinterverfahren zu verbinden.

Ausführungsformen der Erfindung betreffen die Verbindung von LED mit Leadframe, von LED mit keramischem Substrat, von Dies, Dioden, IGBTs oder ICs mit Leadframes, keramischen Substraten oder DCB-Substraten, von Sensor mit Leadframe oder keramischem Substrat. Die Verbindung kann beispielsweise zwischen Aluminium-, Kupfer- oder Silberkontaktflächen der Bauelemente mit Aluminium-, Kupfer- oder Silberkontaktflächen der Substrate erfolgen, d.h. es kann zur Ausbildung beispielsweise einer Aluminium-Kupfer-, Aluminium-Silber-, Aluminium-Aluminium-, Kupfer-Silber-, Kupfer-Kupfer- oder Silber-Silber-Verbindung kommen.

Wie im vorhergehenden Absatz schon beschrieben, können die Bauelemente - soweit sie nicht ohnehin aus Metall bestehen - wenigstens eine Metallisierungsschicht umfassen. Diese Metallisierungsschicht ist vorzugsweise Teil des Bauelements. Die Metallisierungsschicht befindet sich vorzugsweise an wenigstens einer Oberfläche des Bauelements.

Die Verbindung der Bauelemente wird mittels des aus der erfindungsgemäßen Metallzubereitung durch Sprühauftrag hergestellten Sintermittels bevorzugt über besagte Metallisierungsschicht bzw. -schichten vorgenommen.

Die Metallisierungsschicht kann reines Metall aufweisen. So kann es bevorzugt sein, wenn die Metallisierungsschicht wenigstens 50 Gew.-%, mehr bevorzugt wenigstens 70 Gew.-%, noch mehr bevorzugt wenigstens 90 Gew.-% oder aber 100 Gew.-% an reinem Metall aufweist. Das reine Metall ist beispielsweise aus der Gruppe ausgewählt, die aus Aluminium, Kupfer, Silber, Gold, Palladium und Platin besteht.

Andererseits kann die Metallisierungsschicht auch eine Legierung aufweisen. Die Legierung der Metallisierungsschicht enthält vorzugsweise wenigstens ein Metall, das aus der Gruppe ausgewählt ist, die aus Aluminium, Silber, Kupfer, Gold, Nickel, Palladium und Platin besteht.

Die Metallisierungsschicht kann auch einen mehrlagigen Aufbau aufweisen. So kann es beispielsweise bevorzugt sein, wenn wenigstens eine Oberfläche der zu verbindenden Bauelemente eine Metallisierungsschicht aus mehreren Lagen umfasst, die die vorstehend genannten reinen Metalle und/oder Legierungen aufweisen.

Im erfindungsgemäßen Verfahren werden wenigstens zwei Bauelemente durch Sintern miteinander verbunden.

Dazu werden zunächst die zwei oder mehr Bauelemente miteinander in Kontakt gebracht. Das Kontaktieren erfolgt dabei über das aus der erfindungsgemäßen Metallzubereitung durch Sprühauftrag applizierte Sintermittel. Zu diesem Zweck wird eine Sandwichanordnung bereitgestellt, bei der sich zwischen jeweils zwei der wenigstens zwei Bauelemente aus der erfindungsgemäßen Metallzubereitung hergestelltes, d.h. durch Sprühauftrag appliziertes Sintermittel befindet. Mit anderen Worten, die erfindungsgemäße Metallzubereitung wird zwecks Herstellung des Sintermittels, oder präziser ausgedrückt, zwecks Herstellung einer Schicht des Sintermittels, auf wenigstens eines der wenigstens zwei Bauelemente bzw. auf eine Kontaktfläche eines der wenigstens zwei Bauelemente durch Sprühauftrag aufgebracht.

Sollen daher zwei Bauelemente, Bauelement 1 und Bauelement 2, miteinander verbunden werden, so befindet sich das aus der erfindungsgemäßen Metallzubereitung hergestellte, d.h. durch Sprühauftrag applizierte Sintermittel vor dem eigentlichen Sintern zwischen Bauelement 1 und Bauelement 2 bzw. zwischen Kontaktflächen der beiden Bauelemente. Andererseits ist es denkbar, dass mehr als zwei Bauelemente miteinander verbunden werden. Beispielsweise können drei Bauelemente, Bauelement 1, Bauelement 2 und Bauelement 3, auf eine Weise miteinander verbunden werden, dass Bauelement 2 zwischen Bauelement 1 und Bauelement 3 liegt. In diesem Fall befindet sich das durch Sprühauftrag aus der erfindungsgemäßen Metallzubereitung hergestellte Sintermittel sowohl zwischen Bauelement 1 und Bauelement 2 als auch zwischen Bauelement 2 und Bauelement 3.

Die einzelnen Bauelemente liegen in einer Sandwichanordnung vor und werden miteinander verbunden. Unter Sandwichanordnung ist eine Anordnung zu verstehen, bei der sich zwei Bauelemente übereinander befinden, wobei die Bauelemente beispielsweise parallel zueinander angeordnet sein können.

Die Sandwichanordnung aus wenigstens zwei Bauelementen und dazwischen befindlichem Sintermittel kann hergestellt werden, indem zunächst eine Kontaktfläche in Form wenigstens eines Anteils einer Oberfläche, beispielsweise einer nichtebenen und/oder saugenden und/oder offenporigen und/oder komplizierte Oberflächentopographie aufweisenden Oberfläche, eines Bauelements 1 durch Sprühauftrag der erfindungsgemäßen Metallzubereitung mit dem Sintermittel bzw. mit einer Schicht des Sintermittels versehen wird. Dabei kann es zweckmäßig sein, das betreffende Bauelement bzw. dessen mit dem Sintermittel zu versehende Kontaktfläche vor und/oder während des Sprühauftrags zu erwärmen, beispielsweise auf eine Temperatur oberhalb Raumtemperatur bis 150 °C, bevorzugt 80 bis 120 °C. Damit kann eine Entfernung oder Verdunstung organischen Lösemittels aus der erfindungsgemäßen Metallzubereitung schon während des Sprühauftrags unterstützt werden. Im Anschluß an die Sprühbeschichtung des Bauelements 1 sowie einen gegebenenfalls durchgeführten, in der weiteren Folge noch beschriebenen Trocknungsschritt kann das andere Bauelement 2 mit seiner Kontaktfläche auf die wie zuvor beschrieben gebildete Sintermittelschicht unter Ausbildung der Sandwichanordnung aufgesetzt werden. Dabei kann die Kontaktfläche des Bauelements 2 unbeschichtet sein oder eine in analoger Weise wie beim Bauelement 1 gebildete Sintermittelschicht aufweisen.

In der vorliegenden Beschreibung und den Ansprüchen wird der Begriff "Sprühauftrag" im Zusammenhang mit der Applikation der erfindungsgemäßen Metallzubereitung zwecks Herstellung des Sintermittels bzw. einer Schicht des Sintermittels benutzt. Sprühauftrag bedeutet dabei ein berührungsloses, unter Zerstäubung der erfindungsgemäßen Metallzubereitung erfolgendes Auftragsverfahren wie Inkjetauftrag, pneumatisches Sprühen oder Airless-Sprühen. Beim Inkjetauftrag können als Sprühorgane im Inkjetdruck übliche Druckvorrichtungen verwendet werden.

Beim pneumatischen und beim Airless-Sprühen können in der Beschichtungstechnologie übliche Sprühorgane verwendet werden, beispielsweise Spritzpistolen. Der Sprühauftrag kann manuell oder mittels eines Beschichtungsautomaten oder -roboters erfolgen. Der Beschichtungsvorgang kann in einem oder in mehrmals wiederholten Schritten erfolgen. Ein in mehrmals wiederholten Schritten durchgeführter Sprühauftrag stellt eine Möglichkeit dar, die Schichtdicke der Sintermittelschicht nach Wunsch auszubilden. Beim Beschichtungsvorgang können Stellen des oder der Bauelemente, die nicht beschichtet werden sollen, in geeigneter Weise abgedeckt werden, beispielsweise durch Abkleben oder Abdecken mit Schablonen.

Wie gesagt, im Anschluss an den Sprühauftrag der erfindungsgemäßen Metallzubereitung wird die mit dem Sintermittel versehene Oberfläche bzw. Kontaktfläche des einen Bauelements mit einer Oberfläche bzw. Kontaktfläche des damit zu verbindenden Bauelements über das Sintermittel in Kontakt gebracht. Somit befindet sich zwischen zu verbindenden Bauelementen eine Schicht des aus der erfindungsgemäßen Metallzubereitung per Sprühauftrag applizierten Sintermittels.

Die Nassschichtdicke des Sintermittels zwischen zu verbindenden Bauelementen liegt vorzugsweise im Bereich von 10 bis 100 µm, bevorzugt 20 bis 40 µm. Unter Nassschichtdicke wird der Abstand zwischen den einander gegenüberliegenden Oberflächen bzw. Kontaktflächen der zu verbindenden Bauelemente vor einem gegebenenfalls stattfindenden Trocknen und vor dem Sintern verstanden. Über die Häufigkeit der Beschichtungsschritte und/oder die Durchflußrate (pro Zeiteinheit sprühappliziertes Volumen an erfindungsgemäßer Metallzubereitung) und/oder die Bewegungsgeschwindigkeit des oder der eingesetzten Sprühorgane kann die Nassschichtdicke der Sintermittelschicht nach Wunsch eingestellt werden.

Während des Sprühauftrags der erfindungsgemäßen Metallzubereitung werden Tröpfchen gebildet, die auf ihrem Weg vom Sprühorgan zur zu beschichtenden Bauelementoberfläche organisches Lösemittel in die Umgebungsluft abgeben. Mit anderen Worten, beim Auftreffen auf die zu beschichtende Bauelementoberfläche hat der Anteil an organischem Lösemittel abgenommen, beispielsweise um 30 bis 70 %, bezogen auf den ursprünglichen Anteil an organischem Lösemittel in der erfindungsgemäßen Metallzubereitung, d.h. zur Sprühapplikation bereiten Metallzubereitung. Beispielsweise liegt der Gehalt an organischem Lösemittel im unmittelbar zuvor aus der erfindungsgemäßen Metallzubereitung sprühapplizierten Sintermittel bei 10 bis 20 Gew.-%.

Vor dem Sintern kann, wie schon gesagt, ein Trocknungsschritt durchgeführt werden, d.h. eine Entfernung von organischem Lösemittel aus dem Sintermittel. Gemäß einer Ausführungsform liegt der Anteil an organischem Lösemittel in dem Sintermittel nach einer solchen Trocknung beispielsweise bei 0 bis 5 Gew.-%, bezogen auf den ursprünglichen Anteil an organischem Lösemittel in der erfindungsgemäßen Metallzubereitung. Mit anderen Worten, gemäß dieser Ausführungsform werden beispielsweise 95 bis 100 Gew.-% des oder der ursprünglich in der erfindungsgemäßen Metallzubereitung enthaltenen organischen Lösemittel bei einer solchen Trocknung entfernt.

Findet ein Trocknen statt, so kann die Trocknung im Falle des drucklosen Sinterns nach der Herstellung der Sandwichanordnung, also nach der Kontaktierung der zu verbindenden Bauelemente erfolgen. Im Falle des Drucksinterns kann die Trocknung auch nach dem Sprühauftrag der erfindungsgemäßen Metallzubereitung auf die wenigstens eine Oberfläche des Bauelements und vor der Kontaktierung mit dem zu verbindenden Bauelement erfolgen.

Die Trocknungstemperatur liegt vorzugsweise im Bereich von 50 bis 150 °C (Objekttemperatur).

Es versteht sich, dass die Trocknungszeit abhängig ist von der Zusammensetzung der erfindungsgemäßen Metallzubereitung bzw. der daraus durch Sprühauftrag hergestellten Schicht aus Sintermittel und der Größe der Verbindungsfläche der zu sinternden Sandwichanordnung. Die Trocknungszeiten liegen im Bereich von beispielsweise 5 bis 45 Minuten.

Die Sandwichanordnung aus den wenigstens zwei Bauelementen und dem dazwischen befindlichen Sintermittel wird schließlich einem Sinterprozess unterworfen.

Das eigentliche Sintern erfolgt bei einer Temperatur von beispielsweise 200 bis 250 °C entweder als druckloser Prozess oder als Drucksintern.

Beim Drucksintern liegt der Prozessdruck vorzugsweise unter 40 MPa und mehr bevorzugt unter 5 MPa. Beispielsweise liegt der Prozessdruck im Bereich von 1 bis 30 MPa und mehr bevorzugt im Bereich von 1 bis 5 MPa.

Die Sinterzeit liegt beispielsweise im Bereich von 2 bis 60 Minuten, beim Drucksintern beispielsweise im Bereich von 2 bis 5 Minuten, beim Drucklossintern beispielsweise im Bereich von 30 bis 60 Minuten.

Der Sinterprozess kann in einer Atmosphäre erfolgen, die keinen besonderen Beschränkungen unterliegt. So kann das Sintern einerseits in einer Atmosphäre durchgeführt werden, die Sauerstoff enthält. Andererseits ist es auch möglich, das Sintern in sauerstofffreier Atmosphäre durchzuführen. Unter sauerstofffreier Atmosphäre ist im Rahmen der Erfindung eine Atmosphäre zu verstehen, deren Sauerstoffgehalt nicht mehr als 10 ppm, vorzugsweise nicht mehr als 1 ppm und noch mehr bevorzugt nicht mehr als 0,1 ppm beträgt.

Das Sintern wird in einer herkömmlichen, zum Sintern geeigneten Vorrichtung durchgeführt, in der sich die vorstehend beschriebenen Prozessparameter einstellen lassen.

Es konnte festgestellt werden, dass die mit dem erfindungsgemäßen Verfahren bzw. unter Verwendung der erfindungsgemäßen Metallzubereitung geschaffenen Sinterverbindungen innerhalb als auch zur Bauelementkontaktfläche hin keine oder in nur geringem Maße Hohlräume aufweisen, was der Haftung, Festigkeit und Wärmeleitfähigkeit der Sinterverbindung zuträglich ist. Ferner hat sich gezeigt, dass das erfindungsgemäße Verfahren zu einer weitgehend horizontalen, d.h. parallel zur beschichteten Oberfläche orientierten Ausrichtung von Metallflakes innerhalb der Sintermittelschicht führt. Es wird angenommen, dass letzteres Verhalten der Metallflakes das Risiko der Beschädigung oder Zerstörung von druckempfindlichen, beispielsweise zerbrechlichen oder in ihrem Gefüge mechanisch empfindlichen Bauelementen beim Sintern mindert.

Die Erfindung wird im Folgenden anhand von Beispielen erläutert, die jedoch nicht als einschränkend verstanden werden sollen.

### Beispiele

### 1. Herstellung erfindungsgemäßer Metallzubereitungen:

Zunächst wurden die erfindungsgemäßen Metallzubereitungen 1 bis 3 durch Vermischen der einzelnen Bestandteile gemäß nachfolgender Tabelle hergestellt. Alle Mengenangaben bedeuten Gew.-%.

| | Metallzubereitung | | |
|---|---|---|---|
| | 1 | 2 | 3 |
| Silberpartikel ¹⁾ | 70 | 62 | 45 |
| Exxsol™ D60 | 15 | 19,5 | 14 |
| Terpineol | 14,7 | 18,1 | 39 |
| Ethylcellulose | 0,3 | 0,4 | 2 |
| | | | |
| Summe | 100 | 100 | 100 |

| | | | |
|---|---|---|---|
| ¹⁾ Silberflakes mit einem mittleren Teilchendurchmesser (d50) von 4,50 µm und einem Coating von 0,7 Gew.-% Oktansäure/Stearinsäure (Gewichtsverhältnis 1:1) | | | |

### 2. Sprühapplikation und Drucksintern der Metallzubereitungen:

Die Metallzubereitungen 1 bis 3 wurden mittels Sprühauftrag unter Verwendung eines Lackierautomaten (Lackierautomat DD-500 der Fa. DIMA, Sprühdruck 1,4 bar) in 150 µm tiefe rechteckige Kavitäten (4 · 6 mm²) eines 500 µm dicken galvanisch versilberten Kupferblechs in einer Nassschichtdicke von 30 µm appliziert. Zum Schutz der die Kavitäten umgebenden Flächen wurde eine 100 µm- Edelstahlschablone so über dem versilberten Kupferblech angeordnet, dass sich die durch Sprühen zu beschichtenden Kavitäten direkt unter den Öffnungen der Schablone befanden.

Der Lackierautomat DD-500 war so programmiert, dass der Sprühauftrag durch ein gezieltes Abfahren der Schablonenöffnungen mit möglichst geringer Entstehung von Overspray erfolgte. Über die Bewegungsgeschwindigkeit des Sprühorgans konnte eine Sintermittelschicht mit gleichmäßiger Dicke erhalten werden.

Das so partiell sprühbeschichtete versilberte Kupferblech wurde 15 Minuten bei 120 °C Objekttemperatur im Umluft-Trockenschrank getrocknet, um während der Sprühapplikation nicht verdunstetes Lösemittel weitestgehend zu entfernen.

Anschließend wurde das Sintermittel in Form der getrockneten Metallzubereitung mit Siliziumchips mit Silberkontaktfläche (4 · 6 mm²) in Kontakt gebracht. Das anschließende Sintern erfolgte bei einem Sinterdruck von 20 MPa, einer Sintertemperatur von 230°C und einer Sinterdauer von 2 Minuten. Die dabei zwischen den Siliziumchips und dem versilberten Kupferblech gebildete Sinterverbindung erreichte eine zufriedenstellende Festigkeit.

## Patentansprüche

1. Metallzubereitung, die (A) 40 bis < 80 Gew.-% wenigstens eines Metalls, das in Form von Partikeln vorliegt, die ein Coating aufweisen, das wenigstens eine organische Verbindung enthält, und (B) > 20 bis 50 Gew.-% organisches Lösemittel umfasst.

2. Metallzubereitung nach Anspruch 1, wobei das wenigstens eine Metall ausgewählt ist aus der aus Kupfer, Silber, Gold, Nickel, Palladium, Platin und Aluminium bestehenden Gruppe.

3. Metallzubereitung nach Anspruch 1 oder 2, wobei die Metallpartikel die Form von Flakes aufweisen.

4. Metallzubereitung nach Anspruch 1, 2 oder 3, wobei die wenigstens eine organische Verbindung ausgewählt ist aus der aus freien Fettsäuren, Fettsäuresalzen und Fettsäureestern bestehenden Gruppe.

5. Metallzubereitung nach einem der vorhergehenden Ansprüche, wobei das organische Lösemittel (B) ein einziges oder ein Gemisch mindestens zweier organischer Lösemittel ist, ausgewählt unter Terpineolen, N-Methyl-2-pyrrolidon, Ethylenglykol, Dimethylacetamid, 1-Tridecanol, 2-Tridecanol, 3-Tridecanol, 4-Tridecanol, 5-Tridecanol, 6-Tridecanol, Isotridecanol, mit Ausnahme einer Methylsubsitution am vorletzten C-Atom unsubstituierten 1-Hydroxy-C16-C20-alkanen, dibasischen Estern, Glycerin, Diethylenglykol, Triethylenglykol und aliphatischen Kohlenwasserstoffen mit 5 bis 32 C-Atomen.

6. Metallzubereitung nach einem der vorhergehenden Ansprüche enthaltend neben den Bestandteilen (A) und (B) 0 bis 12 Gew.-% wenigstens eines Metallprecursors (C), 0 bis 10 Gew.-% wenigstens eines Sinterhilfsmittels (D) und 0 bis 15 Gew.-% eines oder mehrerer weiterer Inhaltsstoffe (E) ausgewählt unter Dispersionsmitteln, Tensiden, Entschäumern, Bindemitteln, Polymeren und/oder viskositätssteuernden Mitteln.

7. Metallzubereitung nach einem der vorhergehenden Ansprüche, **dadurch gekennzeichnet, dass** sie eine Viskosität im Bereich von 1 bis 3 Pa·s aufweist, gemessen nach DIN 53018 (bei 23 °C, CSR-Messung bei einer Scherrate von D = 10 s⁻¹).

8. Verfahren zum Verbinden von Bauelementen, bei dem man (a) eine Sandwichanordnung bereitstellt, die wenigstens (a1) ein Bauelement 1, (a2) ein Bauelement 2 und (a3) ein Sintermittel aufweist, das sich zwischen Bauelement 1 und Bauelement 2 befindet, und (b) die Sandwichanordnung sintert, **dadurch gekennzeichnet, dass** das Sintermittel aus einer Metallzubereitung nach einem der vorhergehenden Ansprüche durch Sprühauftrag appliziert worden ist.

9. Verfahren nach Anspruch 8 umfassend die Schritte:
(i) Bereitstellen wenigstens zweier Bauelemente 1 und 2,
(ii) Sprühapplizieren der Metallzubereitung auf eine eine Kontaktfläche bildende Oberfläche oder Oberflächenanteil wenigstens eines der Bauelemente unter Bildung des Sintermittels,
(iii) Ausbilden der besagten Sandwichanordnung durch Verbinden der Bauelemente über das Sintermittel, und
(iv) Sintern der Sandwichanordnung.

10. Verfahren nach Anspruch 8 oder 9, wobei man unter Druckanwendung oder drucklos sintert.

11. Verfahren nach einem der Ansprüche 8 bis 10, wobei es sich bei den Bauelementen um in der Elektronik verwendete Teile handelt.

12. Verfahren nach einem der Ansprüche 8 bis 11, wobei wenigstens eines der Bauelemente eine nichtebene und/oder saugende und/oder offenporige und/oder komplizierte Oberflächentopographie aufweisende Oberfläche oder einen nichtebenen und/oder saugenden und/oder offenporigen und/oder komplizierte Oberflächentopographie aufweisenden Oberflächenanteil aufweist und wobei die Sandwichanordnung über besagte Oberfläche oder besagten Oberflächenanteil ausgebildet wird.

13. Verfahren nach einem der Ansprüche 8 bis 12, wobei die mit dem Sintermittel zu versehenden Bauelementoberfläche(n) oder der oder die mit dem Sintermittel zu versehende(n) Bauelementoberflächenanteil(e) vor und/oder während des Sprühauftrags der Metallzusammensetzung erwärmt werden.

14. Verfahren nach einem der Ansprüche 8 bis 13, wobei der Sprühauftrag ausgewählt ist unter Inkjetauftrag, pneumatischem Sprühen und Airless-Sprühen.

15. Verfahren nach einem der Ansprüche 8 bis 14, wobei das Sintermittel eine Nassschichtdicke von 10 bis 100 µm aufweist.
